# EUROPEAN PATENT APPLICATION

(11) **EP 4 354 588 A1**
(43) Date of publication of application: **17.04.2024**
(21) Application number: 21967705.1
(22) Date of filing: 16.12.2021
(51) Int. Cl.: H01M 10/48

(54) **BATTERY AND MANUFACTURING METHOD THEREFOR, AND ELECTRIC DEVICE**

(71) Applicant: Contemporary Amperex Technology Co., Limited, Ningde, Fujian 352100 (CN)
(72) Inventor: WU, Linshan, Ningde, Fujian 352100 (CN)
(74) Representative: Ziebig Hengelhaupt Intellectual Property Attorneys Patentanwaltskanzlei PartGmbB
(86) International application number: PCT/CN2021/138927
(87) International publication number: WO 2023/108570

(57) **Abstract**

The disclosure provides a battery and a manufacturing method therefor, and a power consuming device. The battery includes: a sampling apparatus; and at least two battery cells arranged in a first direction, where ends of the battery cells are provided with terminal posts, and an extending direction of the terminal posts protruding from the ends of the battery cells is perpendicular to the first direction. The sampling apparatus includes a sampling element having a built-in sampling signal line, at least two mounting portions are formed on the sampling element, and the mounting portions match side shapes of the terminal posts, so that the mounting portions are closely attached to the terminal posts of the corresponding battery cells; and the sampling apparatus further includes a connection portion connected to the sampling signal line, and the connection portion is configured to electrically connect the mounting portions and the terminal posts. After the sampling apparatus and the battery cells are assembled, the sampling apparatus may not protrude from the surface of the battery cells by fully utilizing a redundant space between the battery cells, to reduce the occupation of a space within the battery by the sampling apparatus. This is conductive to further increasing the energy density of the battery.

## Description

### Technical Field

The present application relates to the field of traction batteries, and in particular, to a battery and a manufacturing method therefor, and a power consuming device.

### Background Art

This part provides only background information related to the present application, which is not necessarily the prior art.

Driven by the continuous update of battery technology and market promotion, high energy density batteries are widely used in many fields, such as electric vehicles and ships. To ensure the normal use of a battery, it is necessary to monitor a working status of battery cells in the battery. For the monitoring of the battery cells, a sampling apparatus is usually mounted in the battery such that working parameters of the battery cells, such as a voltage, a current, and a temperature, can be measured in real time. The sampling apparatus in the related art occupies a lot of space, thus limiting the further increasing of the energy density of the battery.

### Summary of the Invention

An objective of the present application is to provide a battery and a manufacturing method therefor, and a power consuming device, so that the working parameters of battery cells can be monitored, and the energy density of the battery can also be increased. The specific technical solutions are as follows:
An embodiment of a first aspect of the present application proposes a battery, including a sampling apparatus; and at least two battery cells arranged in a first direction, where ends of the battery cells are provided with terminal posts, and an extending direction of the terminal posts protruding from the ends of the battery cells is perpendicular to the first direction. The sampling apparatus includes a sampling element having a built-in sampling signal line, at least two mounting portions are formed on the sampling element, and the mounting portions match side shapes of the terminal posts, so that the mounting portions are closely attached to the terminal posts of the corresponding battery cells; and the sampling apparatus further includes a connection portion connected to the sampling signal line, and the connection portion is configured to electrically connect the mounting portions and the terminal posts.

The at least two mounting portions are formed on the sampling element of the sampling apparatus of the battery according to this embodiment of the present application, and the mounting portions match the side shapes of the terminal posts, so that the mounting portions are closely attached to the terminal posts of the corresponding battery cells. In addition, the mounting portions are electrically connected to the terminal posts of the battery cells by using the connection portion, and then an electrical signal can be collected. After the sampling apparatus and the battery cells are assembled, the sampling apparatus may not protrude from the surface of the battery cells by fully utilizing a redundant space between the battery cells, to reduce the occupation of a space within the battery by the sampling apparatus. This is conductive to further increasing the energy density of the battery.

In some embodiments, the terminal post is cylindrical, the mounting portion is arc-shaped, and the arc-shaped mounting portion is closely attached to the cylindrical terminal post. The terminal post is of a cylindrical structure, and the mounting portion is in an arc shape adapting to the shape of the terminal post. An inner diameter of the mounting portion is equivalent to an outer diameter of the terminal post, so that the mounting portion is closely attached to the terminal post. This reduces the occupation of a space of an energy region of the battery, and increases the energy density of the battery.

In some embodiments, the sampling apparatus further includes a double-sided tape, one side of the double-sided tape is adhered to the mounting portion, and the other side of the double-sided tape is adhered to the terminal post. The double-sided tape fixes the sampling apparatus and the terminal post of the battery, and is low in material cost, light in weight, and small in size, does not occupy the position of the energy region of the battery, and is easy to operate during assembly of the battery.

In some embodiments, each mounting portion corresponds to two pieces of double-sided tapes, and the connection portion is located between the two pieces of double-sided tapes. The two pieces of double-sided tapes are arranged on both sides of the connection portion, which can better fit and fix the connection portion and the terminal post during assembly.

In some embodiments, the double-sided tape is a double-sided foam tape. The double-sided foam tape has the advantages of strong adhesion, good holding power, and strong temperature resistance, and is suitable for the internal temperature environment of the battery. In addition, the double-sided foam tape has good elasticity, and can absorb a dimensional tolerance between the mounting portion and the terminal post during the assembly of the mounting portion and the terminal post.

In some embodiments, the connection portion is a welding pad configured to weld the mounting portion and the terminal post. The mounting portion and the terminal post are fixed through welding with the welding pad. This has the effect of firm connection, and in addition, the welding pad also implements an electrical connection between the sampling apparatus and the terminal post.

In some embodiments, a dimension of the welding pad in a second direction is less than a dimension of the mounting portion in the second direction, and the second direction is perpendicular to the first direction. The mounting portion is greater than the welding pad in the second direction, thereby preventing the welding pad from accidentally touching an end cap of the battery during the mounting, avoiding an external short circuit of the battery cell, and reducing safety risks.

In some embodiments, the sampling element is a flexible printed circuit board. The flexible printed circuit board can be shaped on site based on the size of the terminal post of the battery, and can be pressed and fitted manually or with tooling to better adapt to the shape of the terminal post.

In some embodiments, the sampling apparatus further includes a thermistor, and the thermistor is connected to the welding pad through a heat-conducting structural adhesive. The thermistor is connected to the welding pad, and the thermistor is closer to the terminal post to prevent excessive energy loss during heat conduction, and therefore, the temperature sampling is more accurate.

In some embodiments, the sampling apparatus further includes a connector, the battery further includes a battery management system, and the connector is configured to connect to the battery management system, so as to transmit, to the battery management system, a sampling signal collected by the collection apparatus. One end of the connector is connected to the sampling element, and the other end of the connector is connected to the battery management system, so as to transmit, to the battery management system, an electrical signal collected by the sampling element.

In some embodiments, the battery cells are distributed in a plurality of rows, each row of the battery cells includes at least two of the battery cells connected at least in the second direction, and battery cells in each row of the battery cells are connected in series; and there are a plurality of sampling apparatuses, and a number of battery cells contained in each row of the battery cells is equal to a number of sampling apparatuses. Connecting the battery cells in series can increase the battery voltage, the battery cells are connected in series through terminal posts and terminal posts, and the sampling apparatus is arranged between the battery cells to sample each battery cell.

An embodiment of a second aspect of the present application proposes a manufacturing method for a battery, including: providing at least two battery cells arranged in a first direction, where ends of the battery cells are provided with terminal posts; and providing a sampling apparatus, where the sampling apparatus includes a sampling element having a built-in sampling signal line, at least two mounting portions are formed on the sampling element, and the mounting portions match side shapes of the terminal posts, so that the mounting portions are closely attached to the terminal posts; and the sampling apparatus further includes a welding pad connected to the sampling signal line, the welding pad is arranged on the mounting portions, and the welding pad is further welded to the terminal posts.

The at least two mounting portions are formed on the sampling element of the sampling apparatus of the battery manufactured by using the manufacturing method for a battery according to this embodiment of the present application, and the mounting portions match the side shapes of the terminal posts, so that the mounting portions are closely attached to the terminal posts of the corresponding battery cells. In addition, the mounting portions are electrically connected to the terminal posts of the battery cells by using the connection portion, and then an electrical signal can be collected. After the sampling apparatus and the battery cells are assembled, the sampling apparatus may not protrude from the surface of the battery cells by fully utilizing a redundant space between the battery cells, to reduce the occupation of a space within the battery by the sampling apparatus. This is conductive to further increasing the energy density of the battery.

An embodiment of a third aspect of the present application proposes a power consuming device, including the battery in any embodiment of the foregoing first aspect. The battery is configured to provide electric energy for the power consuming device.

The at least two mounting portions are formed on the sampling element of the sampling apparatus of the battery applied to the power consuming device according to this embodiment of the present application, and the mounting portions match the side shapes of the terminal posts, so that the mounting portions are closely attached to the terminal posts of the corresponding battery cells. In addition, the mounting portions are electrically connected to the terminal posts of the battery cells by using the connection portion, and then an electrical signal can be collected. After the sampling apparatus and the battery cells are assembled, the sampling apparatus may not protrude from the surface of the battery cells by fully utilizing a redundant space between the battery cells, to reduce the occupation of a space within the battery by the sampling apparatus. This is conductive to further increasing the energy density of the battery.

The above description is only an overview of the technical solutions of the present application. In order to more clearly understand the technical means of the present application to implement same according to the contents of the description, and in order to make the above and other objectives, features and advantages of the present application more obvious and understandable, specific implementations of the present application are exemplarily described below.

### Brief Description of the Drawings

In order to more clearly illustrate the technical solutions in the embodiments of the present invention or in the prior art, the accompanying drawings to be used in the description of the embodiments or the prior art will be described briefly below. Obviously, the accompanying drawings in the following description are merely some embodiments of the present invention. For those of ordinary skill in the art, other embodiments may also be derived from these accompanying drawings. In the drawings:
FIG. 1 is a schematic diagram of a structure of a vehicle that uses a battery according to an embodiment of the present application;
FIG. 2 is a schematic diagram of a structure of a battery according to some embodiments of the present application;
FIG. 3 is a schematic assembly diagram of a battery and a sampling apparatus according to some embodiments of the present application;
FIG. 4 is a schematic diagram of a structure of a sampling apparatus according to some embodiments of the present application; and
FIG. 5 is a schematic exploded view of a sampling apparatus according to some embodiments of the present application.

Reference signs are as follows:
vehicle 1, battery 10, controller 30, motor 40;
case 100, case cover 101, case shell 102, battery cell 200, terminal post 210;
sampling apparatus 300, sampling element 310, mounting portion 320, connection portion 330, double-sided tape 340, thermistor 350, connector 360.

### Detailed Description of Embodiments

Embodiments of the technical solutions of the present application will be described in detail below with reference to the accompanying drawings. The following embodiments are merely intended to more clearly illustrate the technical solutions of the present application, so they merely serve as examples, but are not intended to limit the scope of protection of the present application.

Unless otherwise defined, all technical and scientific terms used herein have the same meanings as those commonly understood by those skilled in the art to which the present application belongs. The terms used herein are merely for the purpose of describing specific embodiments, but are not intended to limit the present application. The terms "including" and "having" and any variations thereof in the description and the claims of the present application as well as the brief description of the accompanying drawings described above are intended to cover non-exclusive inclusion.

In the description of the embodiments of the present application, the technical terms "first", "second", etc. are merely used for distinguishing different objects, and are not to be construed as indicating or implying relative importance or implicitly indicating the number, particular order or primary-secondary relationship of the indicated technical features. In the description of the embodiments of the present application, the phrase "a plurality of' means two or more, unless otherwise explicitly and specifically defined.

The phrase "embodiment" mentioned herein means that the specific features, structures, or characteristics described in conjunction with the embodiment can be encompassed in at least one embodiment of the present application. The phrase at various locations in the description does not necessarily refer to the same embodiment, or an independent or alternative embodiment exclusive of another embodiment. Those skilled in the art understand explicitly or implicitly that the embodiment described herein may be combined with another embodiment.

In the description of the embodiments of the present application, the term "and/or" is merely intended to describe the associated relationship of associated objects, indicating that three relationships can exist, for example, A and/or B can include: only A exists, both A and B exist, and only B exists. In addition, the character "j" herein generally indicates an "or" relationship between the associated objects.

In the description of the embodiments of the present application, the term "a plurality of' means two or more (including two), similarly the term "a plurality of groups" means two or more groups (including two groups), and the term "a plurality of pieces" means two or more pieces (including two pieces).

In the description of the embodiments of the present application, the orientation or position relationship indicated by the technical terms "central", "longitudinal", "transverse", "length", "width", "thickness", "upper", "lower", "front"; "rear", "left", "right", "vertical", "horizontal", "top", "bottom", "inner", "outer", "clockwise", "counterclockwise", "axial", "radial", "circumferential", etc. are based on the orientation or position relationship shown in the accompanying drawings and are merely intended to facilitate and simplify the description of the embodiments of the present application, rather than indicating or implying that the apparatus or element considered must have a particular orientation or be constructed and operated in a particular orientation, and therefore not to be construed as limiting the embodiments of the present application.

In the description of the embodiments of the present application, unless otherwise explicitly specified and defined, the technical terms such as "mount", "couple", "connect", and "fix" should be understood in a broad sense, for example, they may be a fixed connection, a detachable connection, or an integrated connection; may be a mechanical connection or an electric connection; and may be a direct connection or an indirect connection by means of an intermediate medium, or may be communication between interiors of two elements or interaction between the two elements. For those of ordinary skill in the art, the specific meanings of the above terms in the embodiments of the present application can be understood according to specific situations.

Driven by the continuous update of battery technology and market promotion, high energy density batteries are widely used in many fields, such as electric vehicles and ships. In practical applications, battery cells cannot be exactly the same as each other. Due to small differences in some parameters between the battery cells (such as a voltage, an internal resistance, and a state of charge (SOC)), the differences between the battery cells will become larger and larger as the usage time increases. Due to the existence of these differences, the consistency of the battery cells becomes poor, which affects the overall performance of the battery, such as the control of charging and discharging and the control of power balance, and may even cause accidents such as severe fires and explosions due to failure to take reasonable control. Therefore, a sampling apparatus for monitoring the battery cells may be provided in the battery, such that timely control and processing can be made when an abnormality is found.

Some sampling apparatuses in the related art are electrically connected to terminal posts of the battery cells to collect signals of some parameters of the battery cells. In addition, the collected signals are transmitted to a battery management system through a flexible flat cable (FFC) or a flexible printed circuit (FPC) board, so as to adjust and control parameters of each battery cell.

The inventors have noticed that as the overall energy density of the battery becomes higher and higher, the technology of directly arranging the battery cells in a case of the battery is more and more widely used. Such a grouping technology omits the relevant structure of the module, omits the structural configuration of a beam in the case, and can arrange more battery cells in a limited space to increase the volumetric energy density. Several battery cells in the case of the battery may alternatively be arranged in two ways. One way is that electrode terminals of the battery cells are all arranged outward, for example, on the top, bottom, or side of the battery, so that various electrical connections or sampling processes of the battery cells can be performed on the outer edge of the battery. The other way is that some of the electrode terminals of the battery cells are inside the battery, that is, some of the battery cells first form a row through electrical connections between the electrode terminals, and electrode terminals of adjacent battery cells in the row of battery cells are opposed to implement an electrical connection. It is difficult to collect signals from electrode terminals inside an accommodation space due to the limitation of an internal space of the battery.

Some existing sampling apparatuses usually include a plastic bracket and a metal sampling ring, where the sampling ring is clamped on the terminal post of the electrode terminal through interference assembly, and is supported by the plastic bracket to collect and transmit electrical signals of the terminal post. However, such a sampling apparatus occupies a lot of space, thus limiting the further increasing of the energy density of the battery. Moreover, during the clamping, the metal sampling ring is difficult to mount, and it is easy to be misaligned, leading to a low mounting efficiency. When overlapping between the terminal post and the top cover of the battery cell is performed, it will cause an external short circuit accident of the battery.

On the basis of the above problems of the sampling apparatus in the battery, the inventors have studied a new sampling apparatus, that is, the sampling apparatus in the present application, where a mounting portion that matches the shape of the side of the terminal post of the battery cell is provided on the sampling element, and then the connection portion is used to electrically connect the mounting portion and the terminal post, omitting complex supporting components, metal domes, wiring harnesses, or other structures. After assembly is completed, the sampling apparatus may not protrude from the surface of the battery cells by fully utilizing a redundant space between the battery cells, to reduce the occupation of a space within the battery by the sampling apparatus. This is conductive to further increasing the energy density of the battery.

The battery disclosed in the embodiments of the present application may be used in, but not limited to, an electrical apparatus such as a vehicle, a ship or an aircraft, etc. The power consuming device may be, but is not limited to, a mobile phone, a tablet, a notebook computer, an electric toy, a power tool, a battery cart, an electric vehicle, a ship, a spacecraft, etc. The electric toy may include a stationary or mobile electric toy, such as a game console, an electric vehicle toy, an electric ship toy, and an electric airplane toy. The spacecraft may include an airplane, a rocket, a space shuttle, a spaceship, etc.

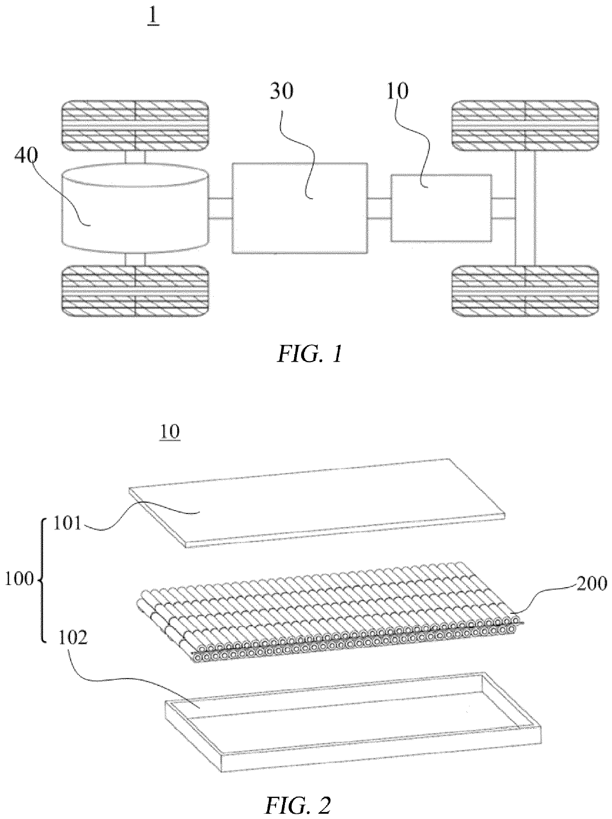

FIG. 1 is a schematic diagram of a structure of a vehicle 1, as a power consuming device, which uses a battery according to an embodiment of the present application. The vehicle 1 may be a fuel vehicle, a gas vehicle, or a new-energy vehicle. The new-energy vehicle may be a battery electric vehicle, a hybrid electric vehicle, an extended-range electric vehicle, etc. The vehicle 1 may be internally provided with a motor 40, a controller 30, and a battery 10. The controller 30 is used for controlling the battery 10 to supply power to the motor 40. For example, the battery 10 may be arranged at a bottom, a head or a tail of the vehicle 1. The battery 10 may be used for supplying power to the vehicle 1. For example, the battery 10 may serve as a power source for operating the vehicle 1 for use in a circuit system of the vehicle 1, for example, to meet the working power demand of the vehicle 1 during startup, navigation and running. In another embodiment of the present application, the battery 10 may not only serve as a power source for operating the vehicle 1, but may also serve as a power source for driving the vehicle 1, instead of or partially instead of fuel or natural air, to provide driving power for the vehicle 1.

As shown in FIG. 2, the battery 10 mentioned in embodiments of the present application refers to a single physical module including one or more battery cells 200 to provide a higher voltage and capacity. For example, the battery 10 mentioned in the present application may include a battery module, a battery pack, etc. The battery 10 usually includes a case 100 for packaging one or more battery cells 200. The case 100 can prevent liquid or other foreign matters from affecting charging or discharging of the battery cells. Specifically, the case 100 may include an upper cover 101 and a case shell 102. The upper cover 101 and the case shell 102 are snap-fitted together. The upper cover 101 and the case shell 102 may be shaped depending on a shape of a combination of a plurality of battery cells 200.

The plurality of battery cells 200 can be connected in series and/or in parallel through terminal posts for various application scenarios. In some high-power application scenarios such as an electric vehicle, the application of the battery includes three levels: a battery cell, a battery module, and a battery pack. The battery module is formed by electrically connecting a certain number of battery cells together and placing same in a frame to protect the battery cells from external shock, heat, vibration, etc. The battery pack is a final state of a battery system that is placed into an electric vehicle. The battery pack generally includes a case for enclosing one or more battery cells. The case can prevent liquid or other foreign matters from affecting charging or discharging of the battery cell(s). The case is usually composed of a cover and a case shell. Most of the current battery packs are made by assembling various control and protection systems such as a battery management system (BMS) and thermal management components on one or more battery modules. With the development of technologies, the battery module may be omitted, that is, the battery pack is directly formed by battery cells. With this improvement, weight energy density and volumetric energy density of the battery system are increased, and the number of parts is remarkably reduced. The battery mentioned in the present application includes a battery module or a battery pack.

In the present application, the battery cell 200 may include a lithium ion secondary battery, a lithium ion primary battery, a lithium-sulfur battery, a sodium-lithium ion battery, a sodium ion battery, a magnesium ion battery, etc., which will not be limited in the embodiments of the present application. The battery cell may be cylindrical, flat, cuboid or in other shapes, which is also not limited in embodiments of the present application. The battery cells are generally classified into three types depending on the way of package: cylindrical battery cells, prismatic battery cells and pouch battery cells, which is also not limited in embodiments of the present application.

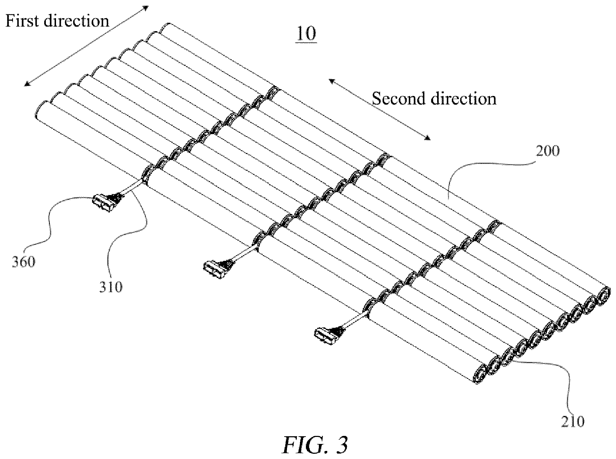

Referring to FIG. 3 to FIG. 5, a first aspect of the present application proposes a battery, including a sampling apparatus 300; and at least two battery cells 200 arranged in a first direction, where ends of the battery cells 200 are provided with terminal posts 210, and an extending direction of the terminal posts 210 protruding from the ends of the battery cells 200 is perpendicular to the first direction. The sampling apparatus 300 includes a sampling element 310 having a built-in sampling signal line, at least two mounting portions 320 are formed on the sampling element 310, and the mounting portions 320 match side shapes of the terminal posts 210, so that the mounting portions 320 are closely attached to the terminal posts 210 of the corresponding battery cells 200; and the sampling apparatus 300 further includes a connection portion 330 connected to the sampling signal line, and the connection portion 330 is configured to electrically connect the mounting portions 320 and the terminal posts 210.

The battery cell 200 is the smallest unit of the battery 10. The battery cell 200 may include an end cap, a housing, a cell assembly, and other functional components, such as an insulation layer. The end cap refers to a component that covers an opening of the housing to isolate an internal environment of the battery cell 200 from an external environment. The housing is a component for accommodating an electrode assembly to form the battery cell 200. The housing further includes electrolyte and other component structures therein. The housing may be made of various materials, such as iron, aluminum, stainless steel, etc., and the electrode assembly is a component in the battery cell 200 where an electrochemical reaction occurs. The housing may include one or more electrode assemblies therein. The electrode assembly is mainly formed by winding or stacking a positive electrode plate and a negative electrode plate, and a separator is generally arranged between the positive electrode plate and the negative electrode plate.

The terminal post 210 is a component that connects the inside and the outside of the battery cell 200, and one end of the terminal post 210 is connected to a cell assembly inside the battery cell 200. The terminal post 210 may protrude from an end cap of the battery cell 200 to connect the terminal posts 210 of the plurality of battery cells 200, such that the battery cells 200 can be connected in series or in parallel.

The end of the battery cell 200 refers to a location where the end cap of the battery cell 200 is located.

For the battery 10, the battery cells 200 contained therein may be arranged in a matrix. For the battery cells 200 arranged in a matrix, there are "rows" and "columns". If the extension direction of the terminal posts 210 protruding from the ends of the battery cells 200 is defined as a "column", then a plurality of battery cells 200 arranged in the "column" direction can be electrically connected by opposing the terminal posts 210. A direction perpendicular to the "column" is the "row". The first direction in the embodiments of the present application refers to the "row".

The sampling apparatus 300 is an apparatus for collecting electrical signals of the battery, which can collect parameters such as the voltages or currents of the battery cells 200, and transmit collected data back to the battery management system.

The sampling element 310 refers to an element in the sampling apparatus 300 that specifically collects signals and transmits the collected electrical signals. For example, the sampling element 310 may be a flexible flat cable (FFC) or a flexible printed circuit (FPC) board, each of which has a built-in sampling signal line for signal collection and transmission. The sampling signal line refers to various wires or cables that can transmit electrical signals.

The mounting portion 320 refers to a part of the structure on the sampling element 310, and the main function of the mounting portion is to enable the sampling element 310 to maintain a relative positional relationship with the battery cell 200. For example, the mounting portion 320 may have a shape that matches the side shape of the terminal post 210 of the battery cell 200, so that the sampling element 310 can maintain a stable relative position with the battery cell 200 in the way that the mounting portion 320 fits the terminal post 210.

The connection portion 330 refers to a structure used to implement the electrical connection relationship between the sampling signal line in the sampling element 310 and the terminal post 210, and is usually a metal part with good electrical conductivity, such as an aluminum part, a nickel part, or a nickel alloy part, which are common.

When the sampling apparatus 300 is applied to the battery, the sampling signal line in the sampling element 310 is electrically connected to the terminal post 210 through the connection portion 330, and a sampling signal representing a parameter state of the battery cell 200 is collected by the sampling signal line through the connection portion 330. The sampling signal line further transmits the sampling signal to the battery management system.

The at least two mounting portions 320 are formed on the sampling element 310 of the sampling apparatus 300 of the battery according to this embodiment of the present application, and the mounting portions 320 match the side shapes of the terminal posts 210, so that the mounting portions 320 are closely attached to the terminal posts 210 of the corresponding battery cells 200. In addition, the mounting portions 320 are electrically connected to the terminal posts 210 of the battery cells 200 by using the connection portion 330, and then an electrical signal can be collected. After the sampling apparatus 300 and the battery cells 200 are assembled, the sampling apparatus 300 may not protrude from the surface of the battery cells 200 by fully utilizing a redundant space between the battery cells 200, to reduce the occupation of a space within the battery 10 by the sampling apparatus 300. This is conductive to further increasing the energy density of the battery 10.

According to some embodiments of the present application, still referring to FIG. 3 to FIG. 5, the terminal post 210 is cylindrical, the mounting portion 320 is arc-shaped, and the arc-shaped mounting portion 320 is closely attached to the cylindrical terminal post 210.

The terminal post 210 is of a cylindrical structure, and the mounting portion 320 is in an arc shape adapting to the shape of the terminal post 210. An inner diameter of the mounting portion 320 is equivalent to an outer diameter of the terminal post 210, so that the mounting portion 320 is closely attached to the terminal post 210. This reduces the occupation of a space of an energy region of the battery 10, and increases the energy density of the battery 10.

According to some embodiments of the present application, the sampling apparatus 300 further includes a double-sided tape 340, one side of the double-sided tape 340 is adhered to the mounting portion 320, and the other side of the double-sided tape 340 is adhered to the terminal post 210.

The double-sided tape 340 is an adhesive tape that can be attached on both sides. Usually, a double-sided tape is made by using paper, cloth, or plastic film as the base material, and then evenly coating the elastomer-based pressure-sensitive adhesive or resin pressure-sensitive adhesive on the above base material.

The double-sided tape 340 is arranged on the side where the mounting portion 320 is combined with the terminal post 210, the mounting portion 320 is mounted on the terminal post 210, and the double-sided tape 340 is used to pre-fix the mounting portion 320 of the sampling apparatus 300 and the terminal post 210. That is, before the connection portion 330 is connected to the terminal post 210 of the battery cell 200, the mounting portion 320 is fixed on the terminal post 210 by using the double-sided tape 340, which facilitate an operation of electrical connection between the connection portion 330 and the terminal post 210. In addition, the double-sided tape 340 is used to pre-fix the sampling apparatus 300 and the terminal post 210, and is low in material cost, light in weight, and small in size, does not occupy the position of the energy region of the battery 10, and is easy to operate during assembly of the battery 10.

According to some embodiments of the present application, each mounting portion 320 corresponds to two pieces of double-sided tapes 340, and the connection portion 330 is located between the two pieces of double-sided tapes 340.

The two pieces of double-sided tapes 340 are arranged on both sides of the connection portion 330, which can better fit and fix the connection portion 330 and the terminal post 210 during assembly.

According to some embodiments of the present application, the double-sided tape 340 is a double-sided foam tape.

The double-sided foam tape may be a PE double-sided foam tape, an EVA double-sided foam tape, a PU double-sided foam tape, an acrylic double-sided foam tape, etc., and is not specially limited in this embodiment.

The double-sided foam tape has the characteristics of strong adhesion, good holding power, and strong temperature resistance. In addition, the double-sided foam tape has good elasticity, and can absorb a dimensional tolerance between the mounting portion 320 and the terminal post 210 during the assembly of the mounting portion and the terminal post.

According to some embodiments of the present application, the connection portion 330 is a welding pad configured to weld the mounting portion 320 and the terminal post 210.

A welding pad refers to a structure on an element that is dedicated to welding with other electrical devices. In this embodiment of the present application, the welding pad is used for welding between the sampling signal line and the electrode 210. The welding pad may be in a shape of a circle, a square, etc., and the welding pad may be made of nickel, aluminum, etc., which is not specifically limited in this embodiment. The welding pad is used to electrically connect the mounting portion 320 and the terminal post 210 to transmit an electrical signal, and may be applied to various welding processes such as laser welding, ultrasonic welding, or soldering.

According to the battery of this embodiment of the present application, the connection portion 330 is a welding pad, that is, the mounting portion 320 and the terminal post 210 are fixed through welding with the welding pad. This has the effect of firm connection, and in addition, the welding pad also implements an electrical connection between the sampling apparatus 300 and the terminal post 210. In this way, a structure of the sampling apparatus 300 is simpler.

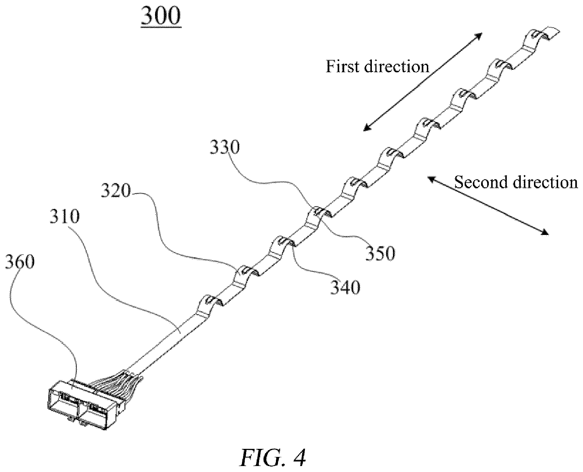

According to some embodiments of the present application, referring to FIG. 4, a dimension of the welding pad in a second direction is less than a dimension of the mounting portion 320 in the second direction, and the second direction is perpendicular to the first direction.

The second direction is an arrangement direction of each row of battery cells 200 in a series state, and along the second direction, the welding pad is arranged in the middle of the mounting portion 320 .

According to the battery of this embodiment of the present application, the mounting portion 320 is greater than the welding pad in the second direction, thereby preventing the welding pad touching the end cap of the battery cell 200 and the terminal post 210 at the same time during the mounting, avoiding an external short circuit of the battery cell 200, and reducing safety risks.

According to some embodiments of the present application, the sampling element 310 is a flexible printed circuit board.

A flexible printed circuit board is a highly reliable pliable printed circuit board made of polyimide or polyester film as the base material, is simply referred to as a soft board or an FPC, and has the characteristics of high wiring density, light weight, and small thickness.

The flexible printed circuit board can be shaped on site based on the size of the terminal post 210, and can be pressed and fitted manually or with tooling to better adapt to the shape of the terminal post 210.

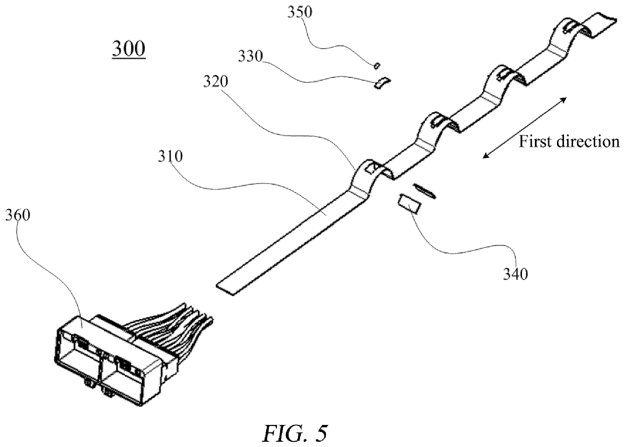

According to some embodiments of the present application, referring to FIG. 4 and FIG. 5, the sampling apparatus 300 further includes a thermistor 350, and the thermistor 350 is connected to the welding pad through a heat-conducting structural adhesive.

The thermistor 350 is a type of sensitive element, which can be divided into positive temperature coefficient thermistor (PTC) and negative temperature coefficient thermistor (NTC) according to different temperature coefficients. A typical characteristic of a thermistor is that it is sensitive to the temperature and exhibits different resistance values at different temperatures. A positive temperature coefficient thermistor (PTC) has a larger resistance value at a higher temperature, and a negative temperature coefficient thermistor (NTC) has a lower resistance value at a higher temperature.

When there is a need to collect a temperature signal of the battery cell 200, a thermistor 350 may also be provided on the sampling apparatus 300. The thermistor 350 is connected to the welding pad, such that the thermistor 350 is closer to the terminal post 210, with a distance less than 5 mm therebetween, to prevent excessive energy loss during heat conduction, and therefore, the temperature sampling is more accurate.

According to some embodiments of the present application, referring to FIG. 3 to FIG. 5, the sampling apparatus 300 further includes a connector 360, the battery 10 further includes a battery management system (not shown in the figure), and the connector 360 is configured to connect to the battery management system, so as to transmit, to the battery management system, a sampling signal collected by the sampling apparatus 300.

The connector 360 refers to a component used to establish an electrical signal transmission relationship between the sampling element 310 and the battery management system. The connector 360 has a shape that matches a signal interface of the battery management system, so that the connector 360 can be connected to the signal interface of the battery management system, so as to establish the electrical signal transmission relationship between the sampling element 310 and the battery management system.

One end of the connector 360 is connected to the sampling element 310, and the other end of the connector is connected to the battery management system, so as to transmit, to the battery management system, an electrical signal collected by the sampling element 310.

According to some embodiments of the present application, the battery cells 200 are distributed in a plurality of rows, each row of the battery cells 200 includes at least two of the battery cells 200 connected at least in the second direction, and battery cells 200 in each row of the battery cells 200 are connected in series; and there are a plurality of sampling apparatuses 300, and a number of battery cells 200 contained in each row of the battery cells 200 is equal to a number of sampling apparatuses 300.

Connecting the battery cells 200 in series can increase the battery voltage, the battery cells 200 are connected in series through terminal posts 210 and terminal posts 210, and the sampling apparatus 300 is arranged between the battery cells 200 to sample each battery cell 200.

According to some embodiments of the present application, a plurality of rows of battery cells 200 are arranged in the first direction, ends of the battery cells 200 are provided with terminal posts 210, and the terminal posts 210 are cylindrical. In the second direction, each row of battery cells 200 has at least two battery cells 200 connected in series through terminal posts 210. In the first direction, in the sampling apparatus 300, corresponding to the series connection position of the terminal posts 210, a mounting portion 320 is correspondingly provided. A connection portion 330 is in the middle of the mounting portion 320, and a dimension of the connection portion 330 is less than that of the mounting portion 320 in the second direction. The mounting portion 320 is in an arc shape adapting to the shape of the terminal post 210. The mounting portion 320 is fitted and mounted on the terminal post 210. The connection portion 330 is electrically connected to the terminal post 210, the end of the sampling element 310 is provided with a connector 360, and an electrical signal collected by the connection portion 330 passes through a sampling signal line in a sampling element 310 and is then transmitted back to a battery management system through the connector 360.

The at least two mounting portions 320 are formed on the sampling element 310 of the sampling apparatus 300 of the battery according to this embodiment of the present application, and the mounting portions 320 match the side shapes of the terminal posts 210, so that the mounting portions 320 are closely attached to the terminal posts 210 of the corresponding battery cells 200. In addition, the mounting portions 320 are electrically connected to the terminal posts 210 of the battery cells 200 by using the connection portion 330, and then an electrical signal can be collected. After the sampling apparatus 300 and the battery cells 200 are assembled, the sampling apparatus 300 may not protrude from the surface of the battery cells 200 by fully utilizing a redundant space between the battery cells 200, to reduce the occupation of a space within the battery 10 by the sampling apparatus 300. This is conductive to further increasing the energy density of the battery 10. In addition, a dimension of the connection portion 330 is less than that of the mounting portion 320, thereby preventing the connection portion 330 from accidentally touching an end cap of the battery during the mounting, avoiding an external short circuit of the battery cell, and reducing safety risks.

A second aspect of the present application proposes a manufacturing method for a battery, including: providing at least two battery cells 200 arranged in a first direction, where ends of the battery cells 200 are provided with terminal posts 210; and providing a sampling apparatus 300, where the sampling apparatus 300 includes a sampling element 310 having a built-in sampling signal line, at least two mounting portions 320 are formed on the sampling element 310, and the mounting portions 320 match side shapes of the terminal posts 210, so that the mounting portions 320 are closely attached to the terminal posts 210; and the sampling apparatus 300 further includes a welding pad connected to the sampling signal line, the welding pad is arranged on the mounting portions 320, and the welding pad is further welded to the terminal posts 210.

The sampling apparatus 300 is an apparatus for collecting electrical signals of the battery cell 200, which can collect parameters such as the voltages or currents of the battery cells 200, and transmit collected data back to the battery management system. The sampling apparatus 300 needs to be electrically connected to the terminal post 210, and is mounted from the side of the terminal post 210 of the battery cell 200. Therefore, the mounting portion 320 of the sampling apparatus 300 adapts to the side shape of the terminal post 210, so as to better fit and mount the mounting portion on the terminal post 210. The connection portion 330 is configured to electrically connect the mounting portion 320 and the terminal post 210, so that the sampling apparatus 300 can collect parameters of the battery cell 200 through electrical signals.

The at least two mounting portions 320 are formed on the sampling element 310 of the sampling apparatus 300 of the battery 10 manufactured by using the manufacturing method for a battery according to this embodiment of the present application, and the mounting portions 320 match the side shapes of the terminal posts 210, so that the mounting portions 320 are closely attached to the terminal posts 210 of the corresponding battery cells 200. In addition, the mounting portions 320 are electrically connected to the terminal posts 210 of the battery cells 200 by using the connection portion 330, and then an electrical signal can be collected. After the sampling apparatus 300 and the battery cells 200 are assembled, the sampling apparatus 300 may not protrude from the surface of the battery cells 200 by fully utilizing a redundant space between the battery cells 200, to reduce the occupation of a space within the battery 10 by the sampling apparatus 300. This is conductive to further increasing the energy density of the battery 10.

A third aspect of the present application proposes a power consuming device, including the battery in any embodiment of the foregoing first aspect. The battery 10 is configured to provide electric energy for the power consuming device.

The at least two mounting portions 320 are formed on the sampling element 310 of the sampling apparatus 300 of the battery 10 applied to the power consuming device according to this embodiment of the present application, and the mounting portions 320 match the side shapes of the terminal posts 210, so that the mounting portions 320 are closely attached to the terminal posts 210 of the corresponding battery cells 200. In addition, the mounting portions 320 are electrically connected to the terminal posts 210 of the battery cells 200 by using the connection portion 330, and then an electrical signal can be collected. After the sampling apparatus 300 and the battery cells 200 are assembled, the sampling apparatus 300 may not protrude from the surface of the battery cells 200 by fully utilizing a redundant space between the battery cells 200, to reduce the occupation of a space within the battery 10 by the sampling apparatus 300. This is conductive to further increasing the energy density of the battery 10.

Finally, it should be noted that the above embodiments are merely used for illustrating rather than limiting the technical solutions of the present application. Although the present application has been illustrated in detail with reference to the foregoing embodiments, it should be understood by those of ordinary skill in the art that the technical solutions described in the foregoing embodiments may still be modified, or some or all of the technical features thereof may be equivalently substituted; and such modifications or substitutions do not make the essence of the corresponding technical solution depart from the scope of the technical solutions of the embodiments of the present application, and should fall within the scope of the claims and the description of the present application. In particular, the technical features mentioned in the embodiments can be combined in any manner, provided that there is no structural conflict. The present application is not limited to the specific embodiments disclosed herein but includes all the technical solutions that fall within the scope of the claims.

## Claims

1. A battery, comprising:
at least two battery cells arranged in a first direction, wherein ends of the battery cells are provided with terminal posts, and an extending direction of the terminal posts protruding from the ends of the battery cells is perpendicular to the first direction; and
a sampling apparatus, wherein the sampling apparatus comprises a sampling element having a built-in sampling signal line, at least two mounting portions are formed on the sampling element, and the mounting portions match side shapes of the terminal posts, so that the mounting portions are closely attached to the terminal posts of the corresponding battery cells; and the sampling apparatus further comprises a connection portion connected to the sampling signal line, and the connection portion is configured to electrically connect the mounting portions and the terminal posts.

2. The battery according to claim 1, wherein the terminal post is cylindrical, the mounting portion is arc-shaped, and the arc-shaped mounting portion is closely attached to the cylindrical terminal post.

3. The battery according to claim 1, wherein the sampling apparatus further comprises a double-sided tape, one side of the double-sided tape is adhered to the mounting portion, and the other side of the double-sided tape is adhered to the terminal post.

4. The battery according to claim 3, wherein each mounting portion corresponds to two pieces of double-sided tapes, and the connection portion is located between the two pieces of double-sided tapes.

5. The battery according to claim 3, wherein the double-sided tape is a double-sided foam tape.

6. The battery according to any one of claims 1 to 5, wherein the connection portion is a welding pad configured to weld the mounting portion and the terminal post.

7. The battery according to claim 6, wherein a dimension of the welding pad in a second direction is less than a dimension of the mounting portion in the second direction, and the second direction is perpendicular to the first direction.

8. The battery according to claim 1, wherein the sampling element is a flexible printed circuit board.

9. The battery according to any one of claims 1 to 8, wherein the sampling apparatus further comprises a thermistor, and the thermistor is connected to the welding pad through a heat-conducting structural adhesive.

10. The battery according to any one of claims 1 to 9, wherein the sampling apparatus further comprises a connector, the battery further comprises a battery management system, and the connector is configured to connect to the battery management system, so as to transmit, to the battery management system, a sampling signal collected by the collection apparatus.

11. The battery according to any one of claims 1 to 10, wherein the battery cells are distributed in a plurality of rows, each row of the battery cells comprises at least two of the battery cells connected at least in the second direction, and battery cells in each row of the battery cells are connected in series; and
there are a plurality of sampling apparatuses, and a number of battery cells contained in each row of the battery cells is equal to a number of sampling apparatuses.

12. A manufacturing method for a battery, comprising:
providing at least two battery cells arranged in a first direction, wherein ends of the battery cells are provided with terminal posts; and
providing a sampling apparatus, wherein the sampling apparatus comprises a sampling element having a built-in sampling signal line, at least two mounting portions are formed on the sampling element, and the mounting portions match side shapes of the terminal posts, so that the mounting portions are closely attached to the terminal posts; and the sampling apparatus further comprises a welding pad connected to the sampling signal line, the welding pad is arranged on the mounting portions, and the welding pad is further welded to the terminal posts.

13. A power consuming device, comprising a battery according to any one of claims 1 to 11.
